# EUROPEAN PATENT APPLICATION

(11) **EP 4 224 228 A1**
(43) Date of publication of application: **09.08.2023**
(21) Application number: 22155387.8
(22) Date of filing: 07.02.2022
(51) Int. Cl.: G02B 6/42, B60K 37/02, G02B 6/08

(54) **METHOD FOR FORMING A 3D DISPLAY STACK**

(71) Applicant: Bayerische Motoren Werke Aktiengesellschaft, 80809 München (DE)
(72) Inventor: Iliffe-Moon, Etienne, Menlo Park, 94025 (US)

(57) **Abstract**

Examples relate to a method (10) for forming a 3D display stack (20). The method (10) comprises providing (11) a first layer (21) comprising a display layer and a touch sensor layer, and attaching (12) a first portion and a second portion of an adhesive layer (22) to a top side of the first layer (21). The method (10) further comprises attaching (13) a cover glass (23) to the first portion of the adhesive layer (22), and attaching (14) a 3D faceplate (24) to the second portion of the adhesive layer (22). Further examples relate to a 3D display stack (20).

## Description

### Field

Examples relate to a method for forming a 3D display stack with a cover glass and a 3D faceplate. The method comprises using an adhesive layer for attaching the 3D faceplate and the cover glass. Further examples relate to a 3D display stack including an adhesive layer, a cover glass, and a 3D faceplate.

### Background

In modern vehicles, user interaction between a user and vehicle systems (e.g. entertainment system, driving system, information system, etc.) is becoming more important as the number of functions of vehicles constantly increases. For example, in view of autonomous driving, the user of a vehicle has much more time to spend with such systems as there might be no more need for driving the car at least in specific situations. For example, user interaction systems and output devices (e.g. displays) are becoming more important to the overall user experience.

For providing an output of the system to the user, larger display screens may be used. For example, digital displays are increasingly replacing analogue gauges, dials and instruments. However, normal digital displays are commonly flat 2D surfaces that lack the perceived value and 3-dimensional detail of an analogue instrument, for example. Current display technology may be limited to two-dimensional (2D) flat surfaces, e.g. due to cost constraints or technological constraints. For example, some other concepts provide flexible displays that can be curved across one axis only. Such displays may be limiting with respect to design of the display surface and may further be cost intensive.

EP 3 916 442 A1 discloses an optical faceplate for a two dimensional display. The disclosure relates to an optical faceplate for use with a two dimensional display. The optical faceplate comprises a contact surface at a bottom side of the optical faceplate for contacting the two dimensional display. The optical faceplate further comprises a three dimensional (3D) display surface at a top side of the optical faceplate, and an optic light guide material provided between the contact surface and the three dimensional display surface. In result, a 3D display system may be achieved.

However, assembling different components of a 3D system may be challenging in some cases, e.g. depending on the design of the display components. It may be difficult to contact different layers and components in a manufacturing process while maintaining a high optical display quality. For example, optical coupling between a display layer and the 3D faceplate might not comply with highest quality standards in all times. In some cases, air bubbles may be enclosed between layers of such displays, causing lower display quality. Visible display defects may bother users and cause non-satisfying user experience.

### Summary

There may be a desire for improved manufacturing processes of 3D displays that help to improve optical coupling between layers of a display stack, and to avoid visible artefacts or defects in the manufactured 3D displays.

This desire is addressed by the subject-matter of the independent claims. Further examples of the proposed concepts are described in the dependent claims, the following description and in combination with the figures.

Embodiments of the present disclosure relate to a method for forming a 3D display stack. The proposed method comprises the steps of providing a first layer comprising a display layer and a touch sensor layer; attaching a first portion and a second portion of an adhesive layer (e.g. film layer or liquid layer) to a top side of the first layer; attaching a cover glass to the first portion of the adhesive layer; and attaching a 3D faceplate to the second portion of the adhesive layer.

A 3D display stack is a display stack with at least one three-dimensional display element. The 3D display stack comprises at least one three-dimensional display portion at the top of the 3D display stack, i.e. at least the 3D faceplate. A 3D display stack formed according to the proposed method may comprise two or more separated 3D faceplates that can be attached to the second portion (e.g. comprising two or more sub-portions) of the adhesive layer. The display layer and the touch sensor layer may be provided either separated (out-cell) or combined (in-cell / on-cell). For example, also 3D touch functionality may be provided.

It should be noticed that the different steps of the proposed method can be performed in different orders according to manufacturing needs and used materials and techniques, e.g. adhesive materials. The adhesive layer may be attached to the first layer before attaching the cover glass and/or 3D faceplate to the adhesive layer, for example. Alternatively, the order can be varied, e.g. the cover glass and/or 3D faceplate can be attached to the adhesive layer before attaching it to the first layer including the display (e.g. using a flip method for bonding cover glass and/or 3D faceplate to the first layer).

The 3D Faceplate can be bonded to a larger display, and therefore be surrounded by a protective layer, referred to as the cover glass. The cover glass may be of any material and not necessarily glass (e.g. may comprise or be a suitable polymer or kind of plastic material).

According to an example, an adhesive layer material extends continuously over the first and second portion of the adhesive layer. For example, a single continuous adhesive film may be used. The adhesive film (e.g. an optically clear adhesive film) including the first and second portion of the adhesive layer may be attached to the first layer in one step. Using a same adhesive layer material for the first and second portion of the adhesive layer may reduce the number of steps of the method and simplify the manufacturing process.

Alternatively, according to another example, the second portion of the adhesive layer is attached separately from the first portion of the adhesive layer (e.g. separated portions). This enables to use different adhesive layer materials for the different portions, for example. Good optical coupling properties may require different adhesive materials for the cover glass and the 3D faceplate, for example. Further, the first portion of the adhesive layer may be attached to the first layer before attaching the cover glass to the first portion of the adhesive layer, while the second portion of the adhesive layer may be attached to the 3D faceplate before attaching the second portion of the adhesive layer to the first layer, for example. It is also possible to use different adhesive layer materials for the first and second portion of the adhesive layer and to attach the first and second portion in a common step, e.g. at the same time. This may enable increased flexibility regarding use of adhesive layer materials without extending the manufacturing process in time.

Accordingly, for example a same adhesive layer material is used for the first and second portion of the adhesive layer. The first and second portion may both be formed by optically clear adhesive (OCA) films (e.g. multiple pieces), e.g. having different thicknesses. This may be beneficial when the cover glass and a base of the 3D faceplate have different thicknesses (this difference may be compensated by different film thicknesses of the first and second portion).

Alternatively, for example different adhesive layer materials are used for the first and second portion of the adhesive layer. Accordingly, optically clear adhesive (OCA), e.g. an OCA film, may be used for bonding the cover glass and optically clear resin (OCR) may be used for bonding the 3D faceplate. The different adhesive layer materials may be selected to enable optimized optical coupling for the different elements of the 3D display stack. For example, optical coupling between the cover glass and the first layer may be better when using a first adhesive layer material compared to a second adhesive layer material, while optical coupling between the 3D faceplate and the first layer may be better when using the second adhesive layer material. For example, as already mentioned before, at least one of an optically clear adhesive (OCA) film material, or an optically clear resin (OCR) film material, or a liquid optically clear adhesive (LOCA) material is used as adhesive layer material.

For example, a liquid optically clear adhesive (LOCA) material is used as adhesive layer material for the second portion of the adhesive layer. Attaching the 3D faceplate comprises pushing the 3D faceplate on the liquid optically clear adhesive material such that the liquid optically clear adhesive material flows into a gap positioned horizontally between the 3D faceplate and the cover glass. Low viscosity OCR may be used to enable material flow. In consequence, after the process the gap is filled with LOCA.

The LOCA or OCR may be dispensed as a drop or pattern (e.g. dependent on the size or shape of the 3D faceplate) such that it flows underneath the 3D faceplate (in the horizontal gap) and displaces any trapped air (if not in a vacuum), and covers the entire face of the 3D faceplate, for example. The LOCA or OCR amount dispensed, material viscosity and the amount of pressure applied to the 3D faceplate will drive the bond thickness. Insufficient LOCA amount, viscosity and pressure will mean the 3D faceplate is not adequately bonded (e.g. visible gaps/voids or trapped air, thus can be avoided in the proposed process. Additional amounts of LOCA or pressure can be used to fill the vertical gap (e.g. positioned horizontally between the edge of the 3D faceplate and edge of the cover glass). According to the proposed method, with accurate control of conditions (e.g. LOCA amount and pressure) the horizontal and vertical gap can be filled without or minimal excess LOCA being squeezed out of the joint (excess adhesive would need to be cleaned up or removed). This can help minimizing manufacturing costs, for example.

For example, using LOCA may require a following step to cure (set, harden, change phase from liquid to solid, etc.) the adhesive, for example this may be done at ambient temperature, elevated temperature, with UV light, etc. Any trapped air or bubbles would need to be prevented or eliminated/removed (e.g. using autoclaving with a vacuum or pressure).

Filling the gap in this way may enable avoiding visible artefacts or defects due to an empty gap between 3D faceplate and cover glass. The gap horizontally between the 3D faceplate and cover glass may exist due to manufacturing tolerances and to enable to position the 3D faceplate beside the cover glass (for example in a cutout or opening of the cover glass).

For example, providing the first layer comprises bonding a touch sensor layer to a top side of the display layer by using an adhesive layer. Using a touch sensor layer separated from the display layer may enable higher flexibility of display - touch sensor combinations. Alternative embodiments may make use of a touch sensor layer that is integrated within the display stack (e.g. by the display manufacturer), e.g. making the manufacturing process easier.

For example, the method may further comprise performing a quality control step at least after one of bonding the touch sensor layer to the top side of the display layer, attaching the cover glass to the first portion of the adhesive layer, or attaching the 3D faceplate to the second portion of the adhesive layer. Quality Control may be required at specific steps or at each step to ensure the lamination is to an acceptable quality level; e.g. is free from trapped air bubbles, defects or foreign bodies. Optionally, the quality control step may incorporate Machine Vision (Machine Learning or AI aspects) to evaluate the visual appearance of the display image across the display/touch stack, cover glass and 3D faceplate. This approach may be used to evaluate, grade, reject, etc. the end result at each Quality Control check point/stage. The learnings from the evaluation may be gathered to provide data or highlight areas for improvement in the process.

For example, the method may further comprise using a mounting tool for attaching the cover glass and/or the 3D faceplate to the adhesive layer. The mounting tool may be adapted to the shape of the 3D faceplate. For example, a sectional view shape of the mounting tool matches a sectional view shape of the 3D portion of the faceplate. The mounting tool may for example improve handling of the 3D faceplate (e.g. by hand, automated machine or robotics), placement, registration or alignment of the 3D faceplate, control pressure distribution across the 3D faceplate, manipulate the angle of the 3D faceplate during bonding (e.g. to facilitate removal of trapped air), etc.

A further aspect relates to a 3D display stack. The 3D display stack comprises a first layer with a display layer and a touch sensor layer. The display layer and the touch sensor layer may be provided as a common layer or in separated sub layers. Further, the 3D display stack comprises an adhesive layer provided on a top side of the first layer, a cover glass (e.g. cover glass layer) provided on a first portion of the adhesive layer, and a 3D faceplate provided on a second portion of the adhesive layer.

The outer boundary of the cover glass may overlap with the outer boundary of the first layer (e.g. aligned). For example, the cover glass may comprise one or more openings for one or more 3D faceplates. The one or more openings are provided above the second portion of the adhesive layer.

For example, the first portion of the adhesive layer differs from the second portion of the adhesive layer. The difference may be the type of material of the first portion and second portion and/or the different thickness of the first and second portion of the adhesive layer. For example, an adhesive layer material of the second portion of the adhesive layer is optically clear resin. For example, the adhesive layer positioned vertically between the 3D faceplate and the first layer has a thickness of at most 10 µm (or at most 5 µm). Thinner adhesive layer thickness may improve the optical coupling quality of the display stack.

According to an aspect, optically clear resin is provided horizontally between the cover glass and the 3D faceplate. As a result, an empty gap between the cover glass and the 3D faceplate can be avoided, helping to avoid visible artefacts, for example. Further, optically clear resin can also be provided vertically between the 3D faceplate and the first layer and/or vertically between the cover glass and the first layer.

### Brief description of the Figures

Some examples of apparatuses and/or methods will be described in the following by way of example only, and with reference to the accompanying figures, in which
- Fig. 1: shows a flow diagram of a manufacturing process for forming a 3D display stack;
- Fig. 2: shows an example of a 3D display stack;
- Fig. 3: shows an exemplary exploded view of a 3D display stack with a continuous adhesive layer;
- Fig. 4: shows an exemplary exploded view of a 3D display stack with different adhesive layer materials of the first and second portion of the adhesive layer;
- Fig. 5: shows an example of using a mounting tool for attaching the 3D faceplate; and
- Fig. 6: shows an example of providing optically clear resin horizontally between the 3D face-plate and the cover glass.

### Detailed Description

Various examples will now be described more fully with reference to the accompanying drawings in which some examples are illustrated. In the figures, the thicknesses of lines, layers and/or regions may be exaggerated for clarity.

Accordingly, while further examples are capable of various modifications and alternative forms, some particular examples thereof are shown in the figures and will subsequently be described in detail. However, this detailed description does not limit further examples to the particular forms described. Further examples may cover all modifications, equivalents, and alternatives falling within the scope of the disclosure. Same or like numbers refer to like or similar elements throughout the description of the figures, which may be implemented identically or in modified form when compared to one another while providing for the same or a similar functionality.

It will be understood that when an element is referred to as being "connected" or "coupled" to another element, the elements may be directly connected or coupled via one or more intervening elements. If two elements A and B are combined using an "or", this is to be understood to disclose all possible combinations, i.e. only A, only B as well as A and B, if not explicitly or implicitly defined otherwise. An alternative wording for the same combinations is "at least one of A and B" or "A and/or B". The same applies, mutatis mutandis, for combinations of more than two Elements.

The terminology used herein for the purpose of describing particular examples is not intended to be limiting for further examples. Whenever a singular form such as "a," "an" and "the" is used and using only a single element is neither explicitly or implicitly defined as being mandatory, further examples may also use plural elements to implement the same functionality. Likewise, when a functionality is subsequently described as being implemented using multiple elements, further examples may implement the same functionality using a single element or processing entity. It will be further understood that the terms "comprises," "comprising," "includes" and/or "including," when used, specify the presence of the stated features, integers, steps, operations, processes, acts, elements and/or components, but do not preclude the presence or addition of one or more other features, integers, steps, operations, processes, acts, elements, components and/or any group thereof.

Unless otherwise defined, all terms (including technical and scientific terms) are used herein in their ordinary meaning of the art to which the examples belong.

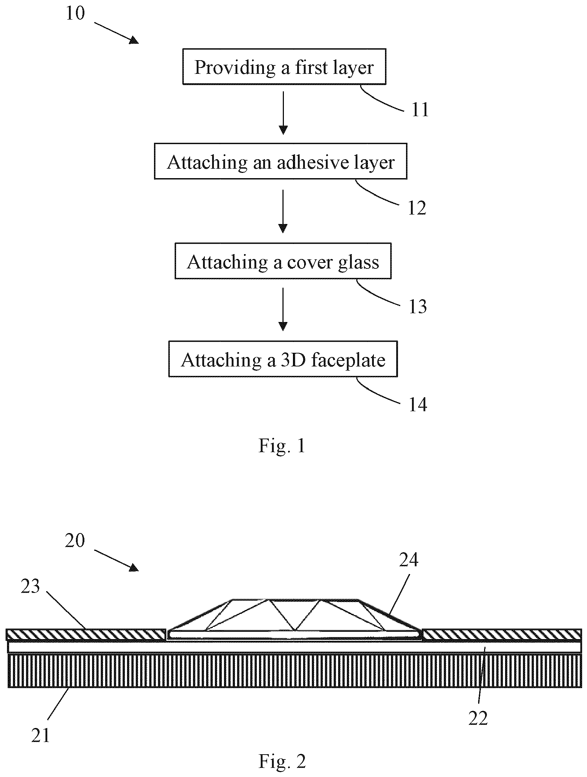

Fig. 1 shows a flow diagram of a manufacturing process for forming a 3D display stack. A shown method 10 comprises providing 11 a first layer comprising a display layer and a touch sensor layer. The method 10 further comprises attaching 12 a first portion and a second portion of an adhesive layer to a top side of the first layer, attaching 13 a cover glass to the first portion of the adhesive layer, and attaching 14 a 3D faceplate to the second portion of the adhesive layer.

All steps may be performed in the order given by the above description or in a different order, e.g. if more appropriate for achieving a high quality product. For example, it may be beneficial in some cases to attach the adhesive layer to the cover glass and/or 3D faceplate before attaching it to the top side of the first layer, e.g. to achieve better optical coupling of the display stack.

More details and aspects of the concept are mentioned in connection with the proposed concept or one or more examples described above or below (e.g. Figs. 2 to 6). The concept may comprise one or more additional optional features corresponding to one or more aspects of the proposed concept or one or more examples described above or below.

Fig. 2 shows an example of a 3D display stack 20. The 3D display stack 20 comprises a first layer 21 with a display layer and a touch sensor layer (shown as a common layer in the example of Fig. 2). The 3D display stack 20 further comprises an adhesive layer 22 provided on a top side of the first layer 21, a cover glass 23 provided on a first portion of the adhesive layer 22, and a 3D faceplate 24 provided on a second portion of the adhesive layer 22.

The 3D display stack 20 may be applied as central display, kombi/instrument cluster and/or rear seat display, e.g. in a vehicle. Further, it may be used in remote controllers, e.g. steering wheel controller or remote controller in a door panel or center arm rest.

More details and aspects of the concept are mentioned in connection with the proposed concept or one or more examples described above or below (e.g. Figs. 1 and 3-6). The concept may comprise one or more additional optional features corresponding to one or more aspects of the proposed concept or one or more examples described above or below.

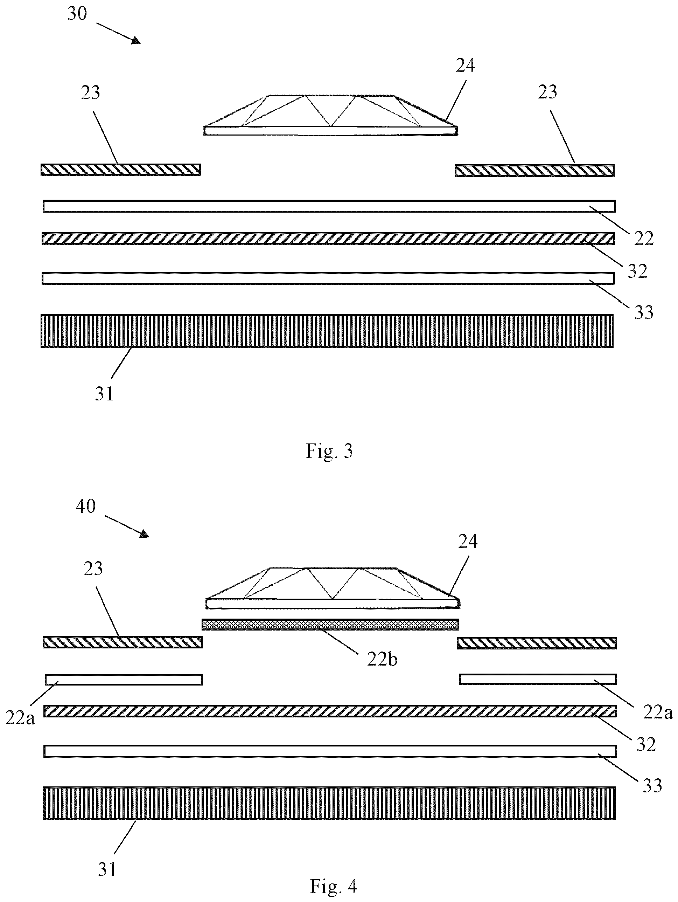

Fig. 3 shows an exemplary exploded view of a 3D display stack 30 with a continuous adhesive layer 22. The continuous adhesive layer 22 may be a single adhesive film of one single adhesive material. A first layer 31 is shown, comprising the display layer. A touch sensor film 32 is bonded to the first layer 31 by an optically clear adhesive (OCA) layer 33. On the top side of the touch sensor film 32, the continuous adhesive layer 22 is provided for laminating the cover glass 23 and the 3D faceplate 24 to the display stack (e.g. in a combined lamination process). The continuous adhesive layer 22 may consist of one continuous adhesive film, e.g. a simplified manufacturing process. Alternatively, the continuous adhesive layer may comprise a same adhesive material (i.e. continuous material property) and comprise multiple pieces of adhesive film, e.g. increasing manufacturing flexibility and giving the possibility for different thicknesses of the single adhesive film pieces.

The given example shows the approach for an Out-Cell touch sensor, where the touch sensor is bonded externally to the display module or display layer. The proposed approach also applies to other configurations, such as On-Cell and In-Cell, for example (on-cell and in-cell configurations may be based on today' s display technology, and that variations or alternatives may arise in the future due to technology advances; e.g. in-cell may become more relevant for OLED displays or MicroLED displays). In the out-cell design, the touch sensor is above the display cell (or display module); e.g. suitable for LCD and OLED displays; e.g. most flexible production approach. In the on-cell design, the touch sensor is placed directly onto the display cell, beneath the display polarizer layer, for example; e.g. suitable for LCD and OLED displays; for example, for LCD displays the touch layer may be above or below the LCD cell; for OLED displays, the touch layer may be above the display cell. In the in-cell design, the touch sensor is placed within the display cell layers; e.g. highly integrated design for mass production possible.

For example, for forming the 3D display stack 30, the OCA layers 22, 33 may be attached to the touch sensor film 32 in a first step. In a following step, the first layer 31 may be attached to the bottom side of the bottom OCA layer 33. Following, the cover glass lamination process and the 3D faceplate lamination process may be performed. Between some or all of these manufacturing steps, quality control steps may be performed. For finalizing the process, an optional display calibration step may be performed. The lamination steps for attaching OCA layers may optionally comprise autoclaving. Lamination techniques used in the process may be roller lamination, screen lamination drum transfer lamination, arc head lamination, glass bending lamination, or roll to sheet lamination.

More details and aspects of the concept are mentioned in connection with the proposed concept or one or more examples described above or below (e.g. Figs. 1-2 and 4-6). The concept may comprise one or more additional optional features corresponding to one or more aspects of the proposed concept or one or more examples described above or below.

Fig. 4 shows an exemplary exploded view of a 3D display stack 40 with different adhesive layer materials. As in Fig. 3, an out-cell touch sensor design is shown. In contrast to the example of Fig. 3, the adhesive layer portion for attaching the cover glass 23 is separated from the adhesive layer portion for attaching the 3D faceplate 24. A first portion 22a of the adhesive layer 22 provided for the cover glass 23 may comprise optically clear adhesive. A second portion 22b of the adhesive layer 22 provided for the 3D faceplate 24 may comprise optically clear resin (liquid based; e.g. liquid optically clear adhesive). This may enable improved optical properties according to the different requirement of the cover glass 23 and the 3D faceplate 24, e.g. comprising different materials themselves.

More details and aspects of the concept are mentioned in connection with the proposed concept or one or more examples described above or below (e.g. Figs. 1-3 and 5-6). The concept may comprise one or more additional optional features corresponding to one or more aspects of the proposed concept or one or more examples described above or below.

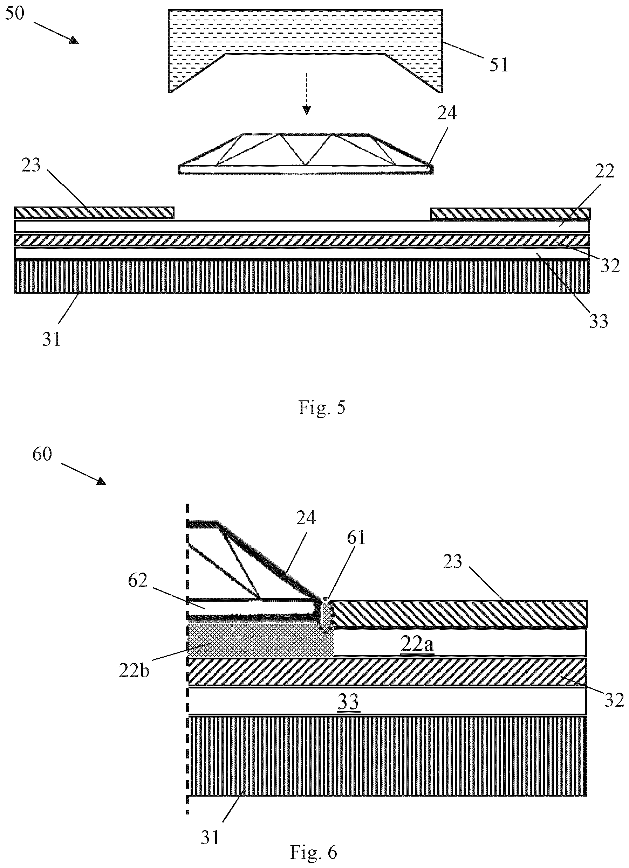

Fig. 5 shows an example 50 of using a fixing or mounting tool 51 for attaching the 3D faceplate 24. The mounting tool 51 is localized to the area of the 3D faceplate 24. The fixture 51 applies pressure and/or locates the 3D faceplate in location in cover glass location (e.g. in the opening of the cover glass 23). Fixture provides e.g. a means for handling the 3D faceplate (by hand, automated machine, robot, etc.), position, orient or align the 3D faceplate, ensure control of pressure (e.g. clamping force) is applied across the 3D faceplate, protect the 3D faceplate during the process, assist in manipulating the 3D faceplate during the bonding process (e.g. control the application angle and means of expelling trapped air), etc. For example, vacuum lamination and/or flip method technique (see also Fig. 6) may be used.

More details and aspects of the concept are mentioned in connection with the proposed concept or one or more examples described above or below (e.g. Figs. 1-4 and 6). The concept may comprise one or more additional optional features corresponding to one or more aspects of the proposed concept or one or more examples described above or below.

Fig. 6 shows an example 60 of providing optically clear resin OCR horizontally between the 3D faceplate and the cover glass. The optically clear resin (or LOCA) fills a gap 61, e.g. due to tolerance of the opening in the cover glass 23, between the 3D faceplate 24 and the cover glass 23. The OCR in the filled gap may be in direct contact with OCR used for the second portion 22b of the adhesive layer 22 for attaching the 3D faceplate 24. For example, liquid OCR (e.g. LOCA) is used for the second portion 22b. In the manufacturing process of bonding the 3D faceplate 24, the adhesive material can flow up to fill the gap 61 around the 3D faceplate (e.g. when applying an appropriate amount of OCR, e.g. low viscosity OCR, and pressure to the 3D faceplate 24 when attaching the 3D faceplate 24). It may be possible that the gap 61 is filled in a secondary process (e.g. after the 3D faceplate is bonded and any trapped air expelled, the gap may then be filled. Alternatively the gap may be partially filled by a trim piece (e.g. opaque plastic or metal) and bonded or mechanically retained in place. Accordingly, the adhesive material filling the gap 61 enables a flush connection of the cover glass 23 and the 3D faceplate 24 leading to improved optical and haptic properties of the 3D display stack.

The OCR layer (i.e. the second portion 22b of the adhesive layer 22) may have a thickness of less than 5 µm, for example. A key goal of the disclosure is to optimize the optical coupling of the 3D faceplate 24 to the display by minimizing the adhesive layer stack up (e.g. thickness) between the 3D faceplate 24 and the display. Using OCR allows thinner adhesive layers, e.g. about 5 µm. The cover glass 23 layer may have a thickness of about 1.1 mm (e.g. less than 2 mm), the OCA layers (e.g. first portion 22a of the adhesive layer and bottom OCA layer 33) may have a thickness of less than 50 µm (e.g. less than 30 µm and/or more than 10 µm). Hence, using the OCR material for the second portion 22b of the adhesive layer 22 for bonding the 3D faceplate may enable very low layer thickness.

The OCR material of the second portion 22b of the adhesive layer for bonding the 3D faceplate may be applied to the touch sensor film 32 or to the back (e.g. bottom side) of the 3D faceplate 24 (e.g. using the flip method). The flip method (or face-down method) performs bonding by stage pressurization while maintaining the parallel state under vacuum pressure or at atmospheric pressure; OCR may be coated in the cover glass by a dispenser; coated cover glass pivot 180 degrees, lower side stage rises up, push OCR radially then bonding. The flip method may be very suited for attaching the 3D faceplate 24 as the 3D faceplate 24 is a rigid body; further, using vacuum lamination may enhances air bubble removal.

For example, the lamination step of attaching the cover glass 23 may use an OCA film for the first portion 22a of the adhesive layer, while the 3D faceplate 24 may be bonded by using OCR or LOCA. Consequently, the 3D faceplate 24 may be bonded separately from the cover glass 23 lamination process.

Using separated portions 22a, 22b of the adhesive layer 22 for laminating the cover glass 23 and the 3D faceplate 24 enables using different thicknesses of the layer portions. For example, the difference in the thickness of the layer portions 22a, 22b can be used to compensate different thicknesses of the cover glass layer 23 and a base 62 of the 3D faceplate 24.

More details and aspects of the concept are mentioned in connection with the proposed concept or one or more examples described above or below (e.g. Figs. 1 to 5). The concept may comprise one or more additional optional features corresponding to one or more aspects of the proposed concept or one or more examples described above or below.

Examples relate to a 3D Display Faceplate Manufacturing Process. Such 3D displays may enable a new form of user interaction when combined with a large 2D (or with some curvature) touchscreen display (e.g. CID/Kombi, Panorama display (P2P/pillar-to-pillar) there are unique user gestures that are now possible relative to the 3D faceplate and surrounding 2D display. The 3D display stack may be used in vehicles, general transportation or consumer electronics (e.g. smart devices, laptops, etc.), for example.

Applying the 3D faceplate 24 to a display or a display with touch sensor (e.g. capacitive) requires an optical coupling to transfer the display image (i.e. light) from the display, into and through the 3D faceplate 24, for example. Bonding the faceplate with an optically clear adhesive provides a good solution to the optical coupling requirement (e.g. thin interface layer, optical index matching, etc.). However the bonding of the 3D Faceplate 24 to the display layer and/or touch sensor layer, requires an optimal manufacturing process, specific steps and configuration of the adhesive layers. This is due to the 3-dimensional nature of the 3D Faceplate - for example: it inherently has 3-dimensional shape, does not match the thickness of the surrounding Cover Glass 23 (e.g. protrudes or extends beyond and/or below; e.g. is of convex and/or concave general form), is a rigid body made of glass or polymer, is a different material to the adjacent materials in the display/sensor stack, etc.

The assembly (e.g. by adhesive bonding with OCA (Optically Clear Adhesive), OCR (Optically Clear Resin) or LOCA (Liquid Optically Clear Adhesive)) of the 3D Faceplate requires a different process or a modified process to what is traditionally used in the display or touchscreen manufacturing process. The configuration of the adhesive layers in the stack may also be different. Different examples are provided:
- Continuous OCA Layer (bonding Cover Glass 23 and Faceplate 24): A single sheet/film of OCA (e.g. continuous adhesive layer 22) is applied to the upper most layer (e.g. touch sensor or display (if no touch sensor)) - the Cover Glass and 3D Faceplate is bonded/laminated simultaneously or sequentially. The manufacturing process requires the Cover Glass 23 be laminated as the last step (in conventional display lamination the Cover Glass is often laminated first.
- Separate OCA Films: Separate or multiple OCA film pieces (e.g. for first 22a and second 22b portion of adhesive layer) are applied to each of the Cover Glass 23 and 3D Faceplate 24. For example the OCA pieces are cut to the shape of the Cover Glass and 3D Faceplate, aligned to the position of the Cover Glass and 3D Faceplate and applied on the display/sensor (or directly aligned and applied onto the Cover Glass and 3D Faceplate) and then laminated (e.g. using a vacuum lamination machine).
- Bonding 3D Faceplate 24 with OCR: The 3D Faceplate 24 is bonded in a separate step, either before or after the Cover Glass is laminated.
- In the above approaches, tooling may be required to position or hold the 3D Faceplate during lamination (e.g. the tooling, e.g. mounting or fixing tool 51, includes details such as alignment features to orient the 3D Faceplate correctly, employ vacuum retention to pick up and hold the 3D Faceplate, etc.).

Examples relate to quality control steps in the manufacturing method: these may be required at each step to ensure the lamination is to an acceptable quality level; e.g. is free from trapped air bubbles, defects or foreign bodies. Additionally the quality control step may incorporate Machine Vision (Machine Learning or AI aspects) to evaluate the visual appearance of the display image across the display/touch stack, Cover Glass and 3D Faceplate. This approach may be used to evaluate, grade, reject, etc. the end result at each Quality Control check point/stage. The earnings from the evaluation may be gathered to provide data or highlight areas for improvement in the process (e.g. application of adhesive, adhesive pattern (e.g. if liquid adhesive), orientation of layers, etc.) - Calibration: As a final step the entire assembly may be calibrated (e.g. color, brightness, contrast, focus, etc.) whereby the output of the display in the region of the 3D Faceplate is adapted to the general output of the display (i.e. in the region of the Cover Glass, or area outside of the 3D Faceplate). An example relates to a method comprising the steps of providing a first layer comprising a display layer and a touch sensor layer; attaching a portion of an adhesive layer (e.g. film layer or liquid layer) to a top side of the first layer; and attaching a 3D faceplate to the portion of the adhesive layer.

The aspects and features mentioned and described together with one or more of the previously detailed examples and figures, may as well be combined with one or more of the other examples in order to replace a like feature of the other example or in order to additionally introduce the feature to the other example.

The description and drawings merely illustrate the principles of the disclosure. Furthermore, all examples recited herein are principally intended expressly to be only for illustrative purposes to aid the reader in understanding the principles of the disclosure and the concepts contributed by the inventor(s) to furthering the art. All statements herein reciting principles, aspects, and examples of the disclosure, as well as specific examples thereof, are intended to encompass equivalents thereof.

A block diagram may, for instance, illustrate a high-level circuit diagram implementing the principles of the disclosure. Similarly, a flow chart, a flow diagram, a state transition diagram, a pseudo code, and the like may represent various processes, operations or steps, which may, for instance, be substantially represented in computer readable medium and so executed by a computer or processor, whether or not such computer or processor is explicitly shown. Methods disclosed in the specification or in the claims may be implemented by a device having means for performing each of the respective acts of these methods.

It is to be understood that the disclosure of multiple acts, processes, operations, steps or functions disclosed in the specification or claims may not be construed as to be within the specific order, unless explicitly or implicitly stated otherwise, for instance for technical reasons. Therefore, the disclosure of multiple acts or functions will not limit these to a particular order unless such acts or functions are not interchangeable for technical reasons. Furthermore, in some examples a single act, function, process, operation or step may include or may be broken into multiple sub-acts, -functions, -processes, -operations or -steps, respectively. Such sub acts may be included and part of the disclosure of this single act unless explicitly excluded.

## Claims

1. A method (10) for forming a 3D display stack (20), the method (10) comprising:
- providing (11) a first layer (21) comprising a display layer and a touch sensor layer;
- attaching (12) a first portion and a second portion of an adhesive layer (22) to a top side of the first layer (21);
- attaching (13) a cover glass (23) to the first portion of the adhesive layer (22); and
- attaching (14) a 3D faceplate (24) to the second portion of the adhesive layer (22).

2. The method (10) according to claim 1,
wherein an adhesive layer material extends continuously over the first and second portion of the adhesive layer (22).

3. The method (10) according to claim 1,
wherein the second portion of the adhesive layer (22) is attached separately from the first portion of the adhesive layer (22).

4. The method (10) according to claim 3,
wherein a same adhesive layer material is used for the first and second portion of the adhesive layer (22).

5. The method (10) according to claim 3,
wherein different adhesive layer materials are used for the first and second portion of the adhesive layer (22).

6. The method (10) according to one of claims 2 to 5,
wherein at least one of an optically clear adhesive film material, or an optically clear resin film material, or a liquid optically clear adhesive material is used as adhesive layer material.

7. The method (10) according to one of claims 2 to 6,
wherein a liquid optically clear adhesive material is used as adhesive layer material for the second portion of the adhesive layer (22),
wherein attaching (14) the 3D faceplate (24) comprises pushing the 3D faceplate (24) on the liquid optically clear adhesive material such that the liquid optically clear adhesive material flows into a gap (61) positioned horizontally between the 3D faceplate (24) and the cover glass (23).

8. The method (10) according to one of claims 1 to 7,
wherein providing (11) the first layer (21) comprises bonding a touch sensor layer (32) to a top side of the display layer by using an adhesive layer (33).

9. The method (10) according to one of claims 1 to 8, further comprising performing a quality control step at least after one of bonding the touch sensor layer to the top side of the display layer, attaching (13) the cover glass to the first portion of the adhesive layer (22), or attaching (14) the 3D faceplate (24) to the second portion of the adhesive layer (22).

10. The method (10) according to one of claims 1 to 9, further comprising using a mounting tool (51) for attaching (13, 14) the cover glass (23) and/or the 3D faceplate (24) to the adhesive layer (22).

11. A 3D display stack (20) comprising:
a first layer (21) with a display layer and a touch sensor layer;
an adhesive layer (22) provided on a top side of the first layer (21);
a cover glass (23) provided on a first portion of the adhesive layer (22); and
a 3D faceplate (24) provided on a second portion of the adhesive layer (22).

12. The 3D display stack (20) according to claim 11,
wherein the first portion (22a) of the adhesive layer (22) differs from the second portion (22b) of the adhesive layer (22).

13. The 3D display stack according to claim 11 or 12,
wherein an adhesive layer material of the second portion (22b) of the adhesive layer (22) is optically clear resin.

14. The 3D display stack according to claim 13,
wherein the adhesive layer (22) positioned vertically between the 3D faceplate (24) and the first layer (21) has a thickness of at most 15 µm.

15. The 3D display stack according to one of claims 11 to 14,
wherein optically clear resin is provided horizontally between the cover glass (23) and the 3D faceplate (24).
